# EUROPEAN PATENT APPLICATION

(11) **EP 4 845 036 A1**
(43) Date of publication of application: **25.11.2026**
(21) Application number: 25751286.3
(22) Date of filing: 23.01.2025
(51) Int. Cl.: H03M 13/11

(54) **ENCODING METHOD AND RELATED PRODUCT**

(30) Priority: 08.02.2024 CN 202410177326
(71) Applicant: Huawei Technologies Co., Ltd., Shenzhen, Guangdong 518129 (CN)
(72) Inventor: LI, Hang, Shenzhen, Guangdong 518129 (CN); ZHENG, Chen, Shenzhen, Guangdong 518129 (CN); DONG, Pengpeng, Shenzhen, Guangdong 518129 (CN)
(74) Representative: Pfenning, Meinig & Partner mbB
(86) International application number: PCT/CN2025/074249
(87) International publication number: WO 2025/167684

(57) **Abstract**

An encoding method and a related product are provided. The method includes: obtaining a first check matrix, and encoding first source bits based on the first check matrix to obtain first encoded bits; segmenting the first encoded bits based on the first check matrix to obtain at least one second encoded bit; and encoding at least one third encoded bit based on the first check matrix to obtain at least one fourth encoded bit, where the at least one second encoded bit includes the at least one third encoded bit. According to the solution of this application, the first source bits are encoded to obtain the first encoded bits, the first encoded bits are segmented, and the encoded bits obtained through segmentation are encoded. Both information bits and first check bits of the first encoded bits are used as information bits for re-encoding, thereby improving design flexibility of the first check matrix, improving encoding efficiency, and improving encoding performance.

## Description

This application claims priority to Chinese Patent Application No. 202410177326.5, filed with the China National Intellectual Property Administration on February 8, 2024 and entitled "ENCODING METHOD AND RELATED PRODUCT", which is incorporated herein by reference in its entirety.

### TECHNICAL FIELD

This application relates to the field of communication technologies, and in particular, to an encoding method and a related product.

### BACKGROUND

With the approaching of 6th generation (6th generation, 6G) mobile communication, real-time high-data-rate applications such as extended reality (extended reality, XR), mixed reality (mixed reality, MR), and immersive services emerge. These emerging services impose higher requirements on both peak throughput and area efficiency of encoding and decoding, with peak rates even required to reach terabits per second (TeraBytes per second, Tbps). In addition, power consumption of decoders need to be further reduced. Apparently, low-density parity-check codes (low-density parity-check code, LDPC) and polar codes (Polar code) of 5th generation (5th generation, 5G) mobile communication cannot meet these high requirements. Therefore, for next-generation chip channel encoding and decoding, technical breakthroughs need to be made in two main directions: high-throughput and low-power-consumption encoding and decoding and high-reliability encoding and decoding, to achieve objectives of future 6G standards through new encoding design and low-complexity decoding design.

A product code has a potential to achieve the high-throughput and low-power-consumption encoding and decoding. However, performance of the code still has great room for improvement.

Therefore, how to improve encoding performance is an urgent problem to be resolved.

### SUMMARY

This application provides an encoding method and a related product, to improve encoding performance.

According to a first aspect, an encoding method is provided. The method includes: obtaining a first check matrix, and encoding first source bits based on the first check matrix to obtain first encoded bits; segmenting the first encoded bits based on the first check matrix to obtain at least one second encoded bit; and encoding at least one third encoded bit based on the first check matrix to obtain at least one fourth encoded bit, where the at least one second encoded bit includes the at least one third encoded bit.

**In** this aspect, the first source bit is encoded to obtain the first encoded bit, the first encoded bit is segmented, and then the encoded bit obtained through segmentation is encoded. The first check matrix used in this aspect is flexibly designed, thereby improving encoding efficiency and improving encoding performance.

With reference to the first aspect, in a possible implementation, before segmenting the first encoded bits based on the first check matrix, the method further includes adjusting a length of the first encoded bits to obtain adjusted first encoded bits; and segmenting the first encoded bits based on the first check matrix includes segmenting the adjusted first encoded bits based on the first check matrix.

**In** this implementation, to make lengths of a plurality of second encoded bits subsequently obtained during segmentation of the first encoded bits uniform, before the first encoded bits are segmented, the length of the first encoded bits may be adjusted to obtain the adjusted first encoded bits.

With reference to the first aspect, in another possible implementation, adjusting the length of the first encoded bits includes padding bits at a head, a tail, and/or a middle position of the first encoded bits.

With reference to the first aspect, in still another possible implementation, before encoding the first source bits based on the first check matrix, the method further includes adjusting a length of the first source bits to obtain adjusted first source bits; and encoding the first source bits based on the first check matrix includes encoding the adjusted first source bits based on the first check matrix.

In this implementation, to make the lengths of the plurality of second encoded bits subsequently obtained during segmentation of the first encoded bit uniform, before the first source bits are encoded, the length of the first source bits may be adjusted to obtain the adjusted first source bits.

With reference to the first aspect, in still another possible implementation, adjusting the length of the first source bits includes padding bits at a head, a tail, and/or a middle position of the first source bits.

With reference to the first aspect, in still another possible implementation, the first encoded bits include information bits and first check bits that are obtained by encoding the first source bits; and the second encoded bit includes a part/all of bits of the information bits and/or a part/all of bits of the first check bits.

In this implementation, all of the first check bits may be appended to a tail of the information bits, and then are evenly segmented. In this way, all of the first check bits are located in later segments. A format of the obtained second encoded bit is as follows.

In an example, the second encoded bit includes a part of bits of the information bits.

In another example, the second encoded bit includes all bits of the information bits.

In still another example, the second encoded bit includes a part of bits of the first check bits.

In still another example, the second encoded bit includes all bits of the first check bits.

In still another example, the second encoded bit includes a part of bits of the information bits and a part of bits of the first check bits.

In still another example, the second encoded bit includes a part of bits of the information bits and all bits of the first check bits.

The first check bits are first evenly divided into *k*₁ segments, and the information bits are also evenly divided into *k*₁ segments, so that the first check bit is evenly placed at a tail of each information bit segment. A format of the obtained second encoded bit is as follows.

In an example, the second encoded bit includes all bits of the information bits and a part of bits of the first check bits.

In another example, the second encoded bit includes all bits of the information bits and all bits of the first check bits.

In still another example, the second encoded bit includes a part of bits of the information bits and a part of bits of the first check bits.

In still another example, the second encoded bit includes all bits of the information bits and a part of bits of the first check bits.

With reference to the first aspect, in still another possible implementation, the first check matrix includes at least one first check submatrix and at least one second check submatrix, the at least one first check submatrix is used to encode the first source bits, and the at least one second check submatrix is used to encode the at least one third encoded bit.

With reference to the first aspect, in still another possible implementation, a value of at least one second element at a tail of one first check submatrix in the at least one first check submatrix is 0, and a position of the at least one second element corresponds to at least one first element at a tail of one second check submatrix in the at least one second check submatrix.

In this implementation, when the at least one third encoded bit is encoded, a feature of the matrix enables flexible generation of redundant bits to be supported, so that the encoding may support flexible code rate adaptation and incremental redundancy hybrid automatic repeat request.

With reference to the first aspect, in still another possible implementation, one first check submatrix in the at least one first check submatrix is obtained by coupling all first check submatrices in a first sliding window length.

In this implementation, the first check submatrix in the at least one first check matrix is obtained by coupling at least one first check submatrix in the first sliding window length, so that the encoding is simpler, hardware complexity is low, decoding is more suitable for being performed in a serial manner, and it is easier for subsequent encoded bits to use decoding information of preceding encoded bits.

With reference to the first aspect, in still another possible implementation, encoding the first source bits based on the first check matrix to obtain the first encoded bits includes: segmenting the first source bits based on the at least one first check submatrix to obtain at least one second source bit; encoding the at least one second source bit based on the at least one first check submatrix to obtain at least one fifth encoded bit; and determining the first encoded bits based on the at least one fifth encoded bit.

In this implementation, to make a length of the at least one second source bit subsequently obtained during segmentation of the adjusted first source bits the same, before the first source bits are segmented, the length of the first source bits may be adjusted to obtain the adjusted first source bits.

With reference to the first aspect, in still another possible implementation, one second check submatrix in the at least one second check submatrix is obtained by coupling all second check submatrices in a second sliding window length.

In this implementation, a second extended matrix may be flexibly cropped (for example, flexible rates mainly require that a quantity of rows of the matrix be different, and the second extended matrix supports cropping from top to bottom to obtain required sizes based on different requirements, but does not affect encoding output results). Therefore, the flexible cropping is a conventional technology of 5G, and in this implementation, the technology is used for coupling of a plurality of encoded bits, so that encoding results can also support a flexible rate change.

With reference to the first aspect, in still another possible implementation, the second check submatrix in the at least one second check submatrix includes a core matrix, an all-zero matrix, a first extended matrix, a diagonal matrix, and a second extended matrix, and the core matrix of the second check submatrix is aligned with the top of a second extended matrix of a previous second check submatrix of the second check submatrix.

With reference to the first aspect, in still another possible implementation, the method further includes determining at least one sixth encoded bit based on the at least one fourth encoded bit.

According to a second aspect, an encoding apparatus is provided, and is configured to implement the encoding method in any one of the first aspect or the implementations of the first aspect. The apparatus may be a transmitter device, a module (for example, a processor, a chip, or a chip system) used in the transmitter device, or a logical node, a logical module, or software that can implement all or a part of functions of the transmitter device.

In a possible implementation, the encoding apparatus in the second aspect includes units configured to separately perform the method in any one of the first aspect or the implementations of the first aspect.

For example, the apparatus includes: an obtaining unit, configured to obtain a first check matrix; and an encoding unit, configured to encode first source bits based on the first check matrix to obtain first encoded bits. The encoding unit is further configured to segment the first encoded bits based on the first check matrix to obtain at least one second encoded bit; and the encoding unit is further configured to encode at least one third encoded bit based on the first check matrix to obtain at least one fourth encoded bit, where the at least one second encoded bit includes the at least one third encoded bit.

Optionally, the apparatus further includes a first adjustment unit, configured to: before the encoding unit segments the first encoded bits based on the first check matrix, adjust a length of the first encoded bits to obtain adjusted first encoded bits. In addition, the encoding unit is further configured to segment the adjusted first encoded bits based on the first check matrix.

Optionally, the first adjustment unit is configured to pad bits at a head, a tail, and/or a middle position of the first encoded bits.

Optionally, the apparatus further includes a second adjustment unit, configured to: before the encoding unit encodes the first source bits based on the first check matrix, adjust a length of the first source bits to obtain adjusted first source bits. In addition, the encoding unit is further configured to encode the adjusted first source bits based on the first check matrix.

Optionally, the second adjustment unit is configured to pad bits at a head, a tail, and/or a middle position of the first source bits.

Optionally, the first encoded bits include information bits and first check bits that are obtained by encoding the source bits; and the second encoded bit includes a part/all of bits of the information bits and/or a part/all of bits of the first check bits.

Optionally, the first check matrix includes at least one first check submatrix and at least one second check submatrix, the at least one first check submatrix is used to encode the first source bits, and the at least one second check submatrix is used to encode the at least one third encoded bit.

Optionally, a value of at least one second element at a tail of one first check submatrix in the at least one first check submatrix is 0, and a position of the at least one second element corresponds to at least one first element at a tail of one second check submatrix in the at least one second check submatrix.

Optionally, one first check submatrix in the at least one first check submatrix is obtained by coupling all first check submatrices in a first sliding window length.

Optionally, the encoding unit is further configured to segment the first source bits based on the at least one first check submatrix to obtain at least one second source bit; the encoding unit is further configured to encode the at least one second source bit based on the at least one first check submatrix to obtain at least one fifth encoded bit; and the encoding unit is further configured to determine the first encoded bits based on the at least one fifth encoded bit.

Optionally, one second check submatrix in the at least one second check submatrix is obtained by coupling all second check submatrices in a second sliding window length.

Optionally, the second check submatrix in the at least one second check submatrix includes a core matrix, an all-zero matrix, a first extended matrix, a diagonal matrix, and a second extended matrix, and the core matrix of the second check submatrix is aligned with the top of a second extended matrix of a previous second check submatrix of the second check submatrix.

Optionally, the apparatus further includes a determining unit, configured to determine at least one sixth encoded bit based on the at least one fourth encoded bit.

In another possible implementation, the encoding apparatus in the second aspect includes a processor coupled to a memory. The processor is configured to implement corresponding functions in the foregoing encoding method performed by the apparatus. The memory is configured to be coupled to the processor, and stores a program (instructions) and/or data necessary for the apparatus. Optionally, the encoding apparatus may further include a communication interface configured to implement communication between the apparatus and another network element. Optionally, the memory may be located inside the encoding apparatus, or may be located outside the encoding apparatus.

In still another possible implementation, the encoding apparatus in the second aspect includes a processor and a transceiver apparatus. The processor is coupled to the transceiver apparatus, and the processor is configured to execute a computer program or instructions, to control the transceiver apparatus to receive and send information. The processor, when executing the computer program or the instructions, is further configured to implement the foregoing method by using a logic circuit or by executing code instructions. The transceiver apparatus may be a transceiver, a transceiver circuit, or an input/output interface, and is configured to: receive a signal from another encoding apparatus different from the encoding apparatus and transmit the signal to the processor, or send a signal from the processor to another encoding apparatus different from the encoding apparatus. When the encoding apparatus is a chip, the transceiver apparatus is a transceiver circuit or an input/output interface.

When the encoding apparatus in the second aspect is the chip, a sending unit may be an output unit, for example, an output circuit or a communication interface; and a receiving unit may be an input unit, for example, an input circuit or a communication interface. When the encoding apparatus is a terminal device, a sending unit may be a transmitter or a transmitter machine; and a receiving unit may be a receiver or a receiver machine.

According to a third aspect, a computer-readable storage medium is provided. The computer-readable storage medium stores a computer program or instructions. When the computer program or the instructions are executed, the method according to the foregoing aspects is implemented.

According to a fourth aspect, a computer program product including instructions is provided. When the instructions are run on an encoding apparatus, the encoding apparatus is enabled to perform the method according to the foregoing aspects.

### BRIEF DESCRIPTION OF DRAWINGS

FIG. 1 is a diagram of a communication scenario;
FIG. 2 is a diagram of sending bits using a product code;
FIG. 3 is a schematic flowchart of an encoding method according to an embodiment of this application;
FIG. 4 is a schematic flowchart of another encoding method according to an embodiment of this application;
FIG. 5 is a diagram of an example of an encoding procedure according to an embodiment of this application;
FIG. 6 is a diagram of an example of a first check matrix according to an embodiment of this application;
FIG. 7 is a diagram of an example of an equal division encoding scheme according to an embodiment of this application;
FIG. 8 is a diagram of an example of an interleaving encoding scheme according to an embodiment of this application;
FIG. 9 is a schematic flowchart of still another encoding method according to an embodiment of this application;
FIG. 10 is a diagram of an example of another encoding procedure according to an embodiment of this application;
FIG. 11 is a diagram of an example of another first check matrix according to an embodiment of this application;
FIG. 12 is a diagram of an example of still another first check matrix according to an embodiment of this application;
FIG. 13 is a diagram of an example of a second check submatrix according to an embodiment of this application;
FIG. 14 is a diagram of an example of still another first check matrix according to an embodiment of this application;
FIG. 15 is a diagram of an example of still another first check matrix according to an embodiment of this application;
FIG. 16 is a diagram of a structure of an encoding apparatus according to an embodiment of this application; and
FIG. 17 is a diagram of a structure of another encoding apparatus according to an embodiment of this application.

### DESCRIPTION OF EMBODIMENTS

The following further describes solutions of this application with reference to accompanying drawings.

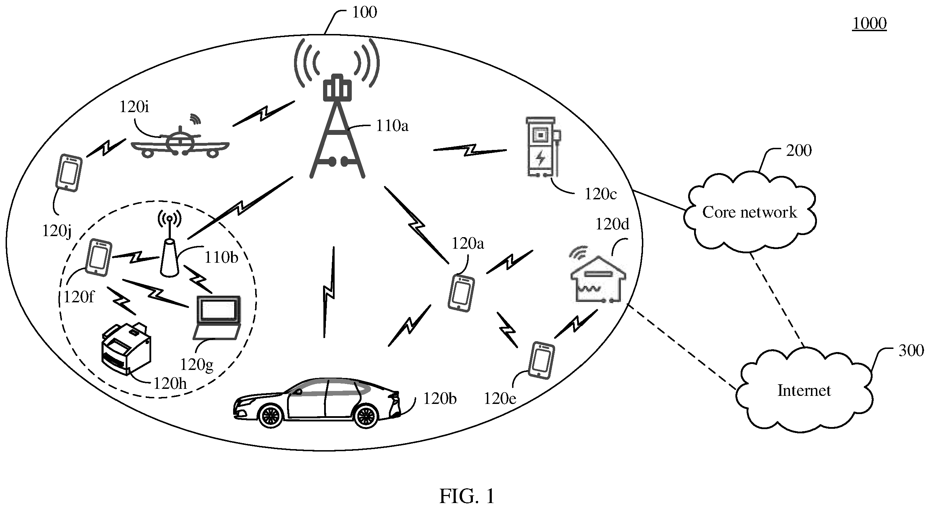

FIG. 1 is a diagram of a possible non-limiting communication system. As shown in FIG. 1, the communication system 1000 includes a radio access network (radio access network, RAN) 100 and a core network (core network, CN) 200. The communication system 1000 may further include an internet 300. The RAN 100 includes at least one RAN node (for example, 110a and 110b in FIG. 1, which are collectively referred to as 110) and at least one terminal device (for example, 120a to 120j in FIG. 1, which are collectively referred to as 120). The RAN 100 may further include another RAN node, for example, a wireless relay device and/or a wireless backhaul device (not shown in FIG. 1). The terminal device 120 is connected to the RAN node 110 in a wireless manner. The RAN node 110 is connected to the core network 200 in a wireless or wired manner. A core network device in the core network 200 and the RAN node 110 in the RAN 100 may respectively be different physical devices, or may be a same physical device that integrates a logical function of the core network and a logical function of the radio access network.

The RAN 100 may be a cellular system related to the 3rd generation partnership project (3rd generation partnership project, 3GPP), for example, a 4G or 5G mobile communication system, or a future-oriented evolved system (for example, a 6G mobile communication system). The RAN 100 may alternatively be an open access network (open RAN, O-RAN or ORAN), a cloud radio access network (cloud radio access network, CRAN), or a wireless fidelity (wireless fidelity, Wi-Fi) system. The RAN 100 may alternatively be a communication system that integrates the foregoing two or more systems.

The RAN node 110 may sometimes also be referred to as an access network device, a RAN entity, an access node, or the like, and forms a part of the communication system, to help the terminal device implement radio access. A plurality of RAN nodes 110 in the communication system 1000 may be nodes of a same type, or may be nodes of different types. In some scenarios, roles of the RAN node 110 and the terminal device 120 are relative. For example, a network element 120i in FIG. 1 may be a helicopter or an uncrewed aerial vehicle, and may be configured as a mobile base station. For a terminal device 120j accessing the RAN 100 via the network element 120i, the network element 120i is a base station. However, for a base station 110a, the network element 120i is a terminal device. Both the RAN node 110 and the terminal device 120 sometimes are referred to as encoding apparatuses. For example, in FIG. 1, network elements 110a and 110b may each be understood as an encoding apparatus having a base station function, and network elements 120a to 120j may each be understood as an encoding apparatus having a terminal device function.

In a possible scenario, the RAN node may be a base station (base station), an evolved NodeB (evolved NodeB, eNodeB), an access point (access point, AP), a transmission reception point (transmission reception point, TRP), a next generation NodeB (next generation NodeB, gNB), a next generation base station in a 6th generation (6th generation, 6G) mobile communication system, a base station in a future mobile communication system, an access node in a Wi-Fi system, or the like. The RAN node may be a macro base station (for example, 110a in FIG. 1), a micro base station or an indoor base station (for example, 110b in FIG. 1), a relay node or a donor node, or a radio controller in a CRAN scenario. Optionally, the RAN node may alternatively be a server, a wearable device, a vehicle, a vehicle-mounted device, or the like. For example, an access network device in a vehicle-to-everything (vehicle-to-everything, V2X) technology may be a road side unit (road side unit, RSU).

In another possible scenario, a plurality of RAN nodes coordinate to assist the terminal device in implementing radio access, and different RAN nodes separately implement a part of functions of the base station. For example, the RAN node may be a central unit (central unit, CU), a distributed unit (distributed unit, DU), a central unit-control plane (central unit-control plane, CU-CP), a central unit-user plane (central unit-user plane, CU-UP), or a radio frequency unit (radio unit, RU). The CU and the DU may be separately arranged, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH).

In different systems, the CU (or the CU-CP and the CU-UP), the DU, or the RU may also have different names, but a person skilled in the art may understand meanings thereof. For example, in an ORAN system, the CU may also be referred to as an open-central unit (open-CU, O-CU), the DU may also be referred to as an open-distributed unit (open-distributed unit, O-DU), the CU-CP may also be referred to as an open-central unit-control plane (open-central unit-control plane, O-CU-CP), the CU-UP may also be referred to as an open-central unit-user plane (open-central unit-user plane, O-CU-UP), and the RU may also be referred to as an open-radio unit (open-radio unit, O-RU). For ease of description, the CU, the CU-CP, the CU-UP, the DU, and the RU are used as examples for description in this application. Any one of the CU (or the CU-CP and the CU-UP), the DU, and the RU in this application may be implemented by a software module, a hardware module, or a combination of a software module and a hardware module.

The terminal device may also be referred to as a terminal, user equipment (user equipment, UE), a mobile station, a mobile terminal device, or the like. The terminal device may be widely used in various scenarios, such as device-to-device (device-to-device, D2D), vehicle-to-everything (vehicle-to-everything, V2X) communication, machine-type communication (machine-type communication, MTC), the internet of things (internet of things, IoT), virtual reality, augmented reality, industrial control, autonomous driving, telemedicine, a smart grid, smart furniture, a smart office, a smart wearable, smart transportation, and a smart city. The terminal device may be a mobile phone, a tablet computer, a computer having a wireless transceiver function, a wearable device, a vehicle, an uncrewed aerial vehicle, a helicopter, an airplane, a ship, a robot, a robotic arm, a smart home device, or the like. A device form of the terminal device is not limited in embodiments of this application.

Communication between the access network device and the terminal device complies with a specific protocol layer structure. Protocol layers may include a control plane protocol layer and a user plane protocol layer. The control plane protocol layer may include at least one of the following: a radio resource control (radio resource control, RRC) layer, a packet data convergence protocol (packet data convergence protocol, PDCP) layer, a radio link control (radio link control, RLC) layer, a media access control (media access control, MAC) layer, a physical (physical, PHY) layer, or the like. The user plane protocol layer may include at least one of the following: a service data adaptation protocol (service data adaptation protocol, SDAP) layer, a PDCP layer, an RLC layer, a MAC layer, a physical layer, or the like.

The base station and the terminal device may be fixed or movable. The base station and the terminal device may be deployed on land, including an indoor or outdoor device, a handheld device, or a vehicle-mounted device; may be deployed on water; or may be deployed on an airplane, a balloon, and an artificial satellite. Application scenarios of the base station and the terminal device are not limited in embodiments of this application.

Roles of the base station and the terminal device may be relative. For example, a helicopter or an uncrewed aerial vehicle 120i in FIG. 1 may be configured as a mobile base station, and for those terminal devices 120j accessing the radio access network 100 via 120i, the terminal device 120i is a base station. However, for a base station 110a, 120i is a terminal device. In other words, communication between 110a and 120i is performed according to a radio air interface protocol. It is clear that communication between 110a and 120i may alternatively be performed according to an interface protocol between base stations. In this case, for 110a, 120i is also a base station. Therefore, both the base station and the terminal device may be collectively referred to as encoding apparatuses. 110a and 110b in FIG. 1 may each be referred to as an encoding apparatus having a base station function, and 120a to 120j in FIG. 1 may each be referred to as an encoding apparatus having a terminal device function.

In embodiments of this application, the base station is also referred to as an access network device. An apparatus configured to implement a function of the access network device may be an access network device, or may be an apparatus that can support the access network device in implementing the function, for example, a chip system, a hardware circuit, a software module, or a combination of a hardware circuit and a software module. The apparatus may be installed in the access network device or used together with the access network device. In embodiments of this application, an example in which the apparatus configured to implement the function of the access network device is an access network device is merely used for description, and constitutes no limitation on the solutions in embodiments of this application.

It may be understood that, this application may be applied to an access network device or a terminal device.

It should be understood that, quantities and types of devices in the communication system shown in FIG. 1 are merely used as an example. This application is not limited thereto. In an actual application, the communication system may further include more terminal devices and more access network devices, and may further include another network element, for example, may include a core network device and/or a network element configured to implement an artificial intelligence function.

It may be understood that, all or a part of functions implemented by one or more of the terminal device, the access network device, the core network device, or the network element configured to implement the artificial intelligence function may be virtualized, that is, implemented by one or more of a dedicated processor or a general-purpose processor and a corresponding software module. Because the terminal device and the access network device are related to an interface for air interface transmission, a transceiver function of the interface may be implemented by hardware. Core network devices such as an operation, administration, and maintenance (operation, administration, and maintenance, OAM) network element may all be virtualized. Optionally, one or more functions of the virtualized terminal device, access network device, core network device, or network element configured to implement the artificial intelligence function may be implemented by a cloud device, for example, implemented by a cloud device in an over-the-top (over-the-top, OTT) system.

Channel coding is one of core technologies in the field of wireless communication. A complete channel coding process includes components such as cyclic redundancy check code addition, code block segmentation, error correction coding, rate adaptation, code block connection, data interleaving, and data scrambling. The error correction coding is a most important part. A purpose of the error correction coding is to ensure that a receiver can automatically correct errors occurring during data transmission with redundant overheads as small as possible. At a same bit error rate, smaller required overheads indicate higher encoding efficiency. Conventional channel encoding and decoding generally include linear block codes (for example, a Hamming code, a Gray code, an error correction code (Bose-Chaudhuri-Hocquenghem code, BCH code), and a Reed-Solomon code (Reed-Solomon code, RS code)), a convolutional code, and a concatenated code. These codes have different features and performance and are applicable to different scenarios.

In 3rd generation (3rd generation, 3G) and 4th generation (4th generation, 4G) mobile communication systems, a concatenated (Turbo) code, as an encoding and decoding technology defined in the 3GPP standard, belongs to a convolutional code with excellent performance, and may very closely approach a limit of Shannon theory. In the era of a 5G mobile communication system, a data transmission rate is increased by an order of magnitude compared with that of 4G. For the Turbo code, a serial processing-based decoder of the Turbo code cannot effectively support such high-speed data transmission. In addition, in the 5G era, other more diverse service application scenarios and new requirements for channel coding emerge. For example, in a massive machine-type communication (massive machine-type communication, mMTC) scenario, a file packet that needs to be transmitted is small; while in an ultra-reliable low-latency communication (ultra-reliable low-latency communication, URLLC) scenario, requirements on an encoding and decoding latency and low bit error rates are high. Therefore, based on the key requirements for channel coding in the three 5G application scenarios, LDPC and Polar are finally used in 5G standards. Compared with conventional linear block codes and convolutional codes, these two types of codes have better performance and may very closely approach the limit of Shannon theory. However, the two types of codes also have different features in terms of applicable scenarios and complexity of a coder/decoder.

With the approaching of 6G, real-time high-data-rate applications such as XR, MR, and immersive services commercially emerge. These emerging services impose higher requirements on both peak throughput and area efficiency of encoding and decoding, with peak rates even required to reach Tbps. In addition, power consumption of decoders need to be further reduced. Apparently, LDPC codes and Polar codes of 5G cannot meet these high requirements. Therefore, for next-generation chip channel encoding and decoding, technical breakthroughs need to be made in two main directions: high-throughput and low-power-consumption encoding and decoding and high-reliability encoding and decoding, to achieve objectives of future 6G standards through new encoding design and low-complexity decoding design.

For the objectives of the future 6G standards, a product code has a potential to achieve the high-throughput and low-power-consumption encoding and decoding. A main idea of the product code is that long codes can be obtained by constructing product codes, and during reception, the high-complexity long codes are decoded to be converted into a plurality of short component codes for processing. Main advantages of the product code are reflected in the following two aspects: First, long codes can be constructed without significantly increasing complexity, and the obtained long codes have better error correction performance than short codes at a same code rate; and second, compared with a manner of constructing the long codes by directly using a single check matrix, decoding complexity (for example, a quantity of iterations) of component codes at a same operating point can be significantly reduced, thereby having higher throughput. Therefore, the product code may be used as an alternative code type for achieving the high-throughput and low-power-consumption encoding and decoding.

A two-dimensional product code includes two component codes 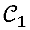 and 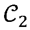 , and usually two-step encoding is completed through row component encoding and column component encoding. During construction of the product code, algebraic codes are often used as the component codes 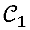 and 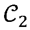 , and this type of product code is widely used.

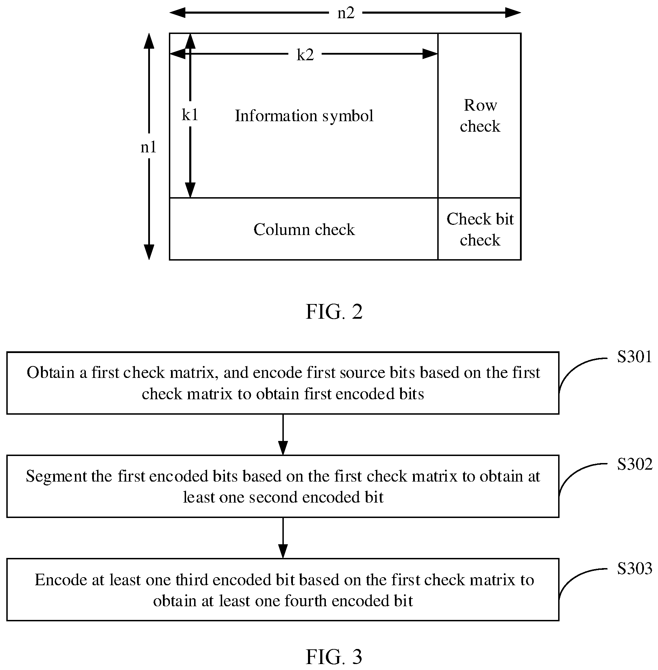

FIG. 2 is a diagram of sending bits using a product code. For example, considering a binary linear code 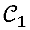 with a code length, an information bit length, and a minimum distance of (*n*₁, *k*₁, *d*₁), and a binary linear code 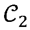 with a code length, an information bit length, and a minimum distance of (*n*₂, *k*₂, *d*₂)*,* the two-dimensional product code may be constructed by using the following method: arranging information bits with a length of *k*₁*k*₂ as a matrix *C*₁ of *k*₁ × *k*₂; encoding each row of *C*₁ based on 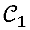 to obtain a matrix *C*₂ of *k*₁ × *n*₂; and encoding each column of *C*₂ based on 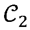 to obtain a matrix C of *n*₁ × *n*₂, which is a two-dimensional product code codeword that is determined by 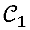 and 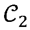 and whose length is *n*₁*n*₂. A code rate of the product code codeword is *k*₁*k*₂/*n*₁*n*₂.

However, for an LDPC-SPC code generated by using the foregoing method, an obtained check matrix structure is fixed, and code performance still has great room for improvement.

In view of this, this application provides an encoding scheme. First source bits are encoded to obtain first encoded bits, the first encoded bits are segmented, and then the encoded bits obtained through segmentation are encoded. A first check matrix used in the encoding scheme is flexibly designed, thereby improving encoding efficiency and improving encoding performance.

The technical solutions provided in embodiments of this application may be applied to channel encoding/decoding between communication devices. The channel encoding/decoding between the communication devices may include channel encoding/decoding between a network device and a terminal device, channel encoding/decoding between network devices, and channel encoding/decoding between terminal devices. In embodiments of this application, the term "channel encoding and decoding" may also be referred to as "coding" for short, and the term "coding" may also be described as "channel encoding and decoding", "network coding", "outer code", or "joint source-channel encoding and decoding". The term "coding structure" may also be referred to as "coding", "code type", or "code design" for short, or the term "coding structure" may also be described as "concatenated code", "layered code", "coupled code", "outer code", "sliding window code", "product code", or "staircase code".

Based on the foregoing communication system, the following describes the encoding method provided in embodiments of this application.

FIG. 3 is a schematic flowchart of an encoding method according to an embodiment of this application. The method is applied to an encoding apparatus, and the encoding apparatus is any transmitter device, for example, a network device or a terminal device. For example, the method may include the following steps.

S301: Obtain a first check matrix, and encode first source bits based on the first check matrix to obtain first encoded bits.

Before performing encoding, the encoding apparatus obtains the first check matrix. The encoding apparatus may obtain the first check matrix from a memory of the encoding apparatus, or obtain the first check matrix from another apparatus or device.

After obtaining the first check matrix, the encoding apparatus encodes the first source bits based on the first check matrix to obtain the first encoded bit.

For example, the encoding apparatus may encode the first source bits based on all or a part of the first check matrix to obtain the first encoded bit.

S302: Segment the first encoded bits based on the first check matrix to obtain at least one second encoded bit.

After obtaining the first encoded bit, the encoding apparatus further segments the first encoded bits based on the first check matrix to obtain the at least one second encoded bit.

A length of the at least one second encoded bit obtained through segmentation may be the same or different.

S303: Encode at least one third encoded bit based on the first check matrix to obtain at least one fourth encoded bit.

After obtaining the at least one second encoded bit through segmentation, the encoding apparatus encodes the at least one third encoded bit based on the first check matrix to obtain the at least one fourth encoded bit.

The at least one second encoded bit includes the at least one third encoded bit, that is, the at least one third encoded bit is a part or all of the at least one second encoded bit.

An existing encoding apparatus always uses LDPC codes and single-bit parity check (signal-bit parity, SPC) codes, with a fixed structure and a large amount of redundancy, and a code rate difficult to be adjusted. In this embodiment, the first source bit is first encoded to obtain the first encoded bit, the first encoded bit is segmented, and then the at least one third encoded bit obtained through segmentation is encoded. This has flexibility in the structure and improves encoding flexibility.

According to the encoding method provided in this embodiment of this application, the first source bits are encoded to obtain the first encoded bits, the first encoded bits are segmented, and then the encoded bits obtained through segmentation are encoded. The first check matrix used in the encoding method is flexibly designed, thereby improving encoding efficiency and improving encoding performance.

In the foregoing embodiments, the length of the at least one second encoded bit obtained through segmentation may be the same or different. When the length of the at least one second encoded bit is the same, a length of the first source bit or the first encoded bit needs to be adjusted to be divisible. When the length of the at least one second encoded bit is different, but the length of the at least one second encoded bit is set, where for example, lengths of three second encoded bits are set to A, B, and C, the length of the first source bits or the first encoded bits needs to be adjusted, so that the lengths of the three second encoded bits are A, B, and C. The following uses an example in which the length of the at least one second encoded bit is the same for description.

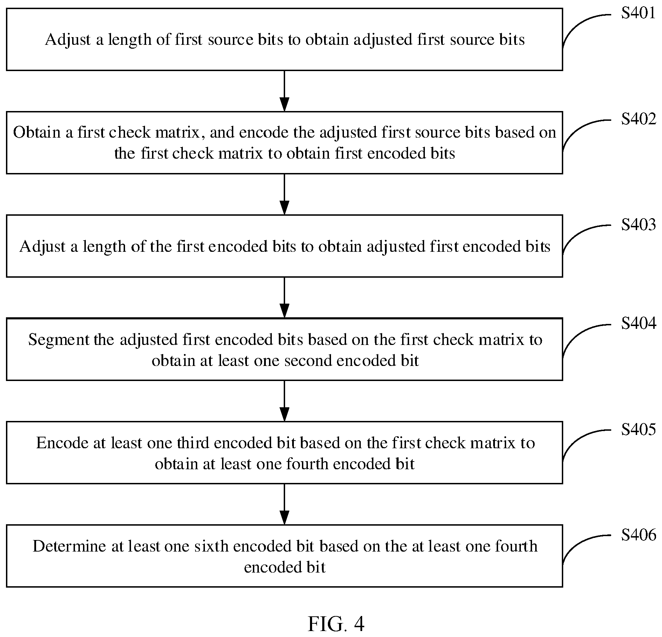

FIG. 4 is a schematic flowchart of another encoding method according to an embodiment of this application. For example, the method may include the following steps.

S401: Adjust a length of first source bits to obtain adjusted first source bits.

To make lengths of a plurality of second encoded bits subsequently obtained during segmentation of first encoded bits the same, before the first source bits are encoded, the length of the first source bits may be adjusted to obtain the adjusted first source bits.

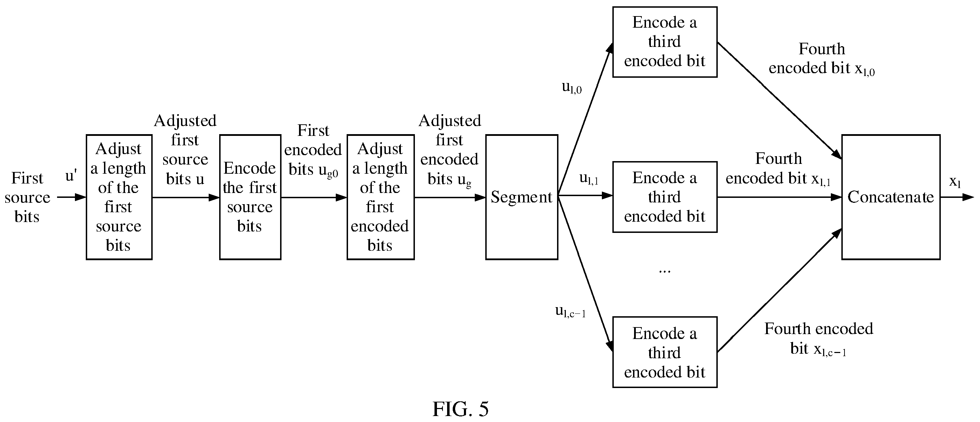

FIG. 5 is a diagram of an example of an encoding procedure according to an embodiment of this application. A length of first source bits u' is *A*' bits, and the first source bits u' are divided into c encoded bits for coupling. In this case, a total length of adjusted first source bits u is *A_{gt}* = *A'+Aₚ.*

There may be the following two manners for *Aₚ.*

In a manner, if *A'* is indivisible by *c*, bits are padded (for example, *Aₚ* 0s are padded) at a head, a tail, and/or a middle position of the first source bits, where ${A}_{p} = A ′ - \left⌊A′/c\right⌋ ⋅ c$*.* $\left⌊A′/c\right⌋$ indicates rounding down of *A'*/*c.* It may be understood that, herein, enabling *A'* to be divisible by c is a manner of enabling subsequent even and uniform segmentation to be performed. This processing manner is not limited in this application.

In another manner, *Aₚ* is fixed to 0, that is, no processing is performed.

S402: Obtain a first check matrix, and encode the adjusted first source bits based on the first check matrix to obtain the first encoded bits.

After the length of the first source bits is adjusted and before the adjusted first source bits are encoded, an encoding apparatus obtains the first check matrix.

For example, the encoding apparatus may obtain the first check matrix from a memory of the encoding apparatus, or obtain the first check matrix from another apparatus or device.

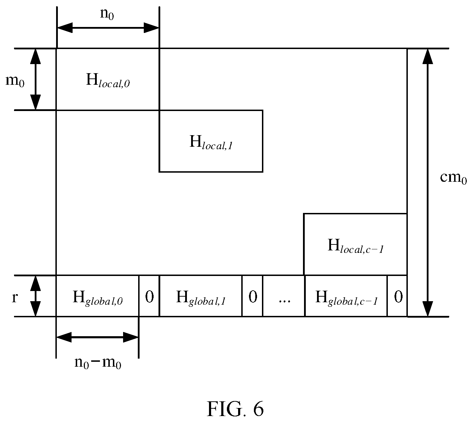

FIG. 6 is a diagram of an example of the first check matrix according to an embodiment of this application. The first check matrix includes at least one first check submatrix (*H_{global} =* [*H*_{*global*,0} *H*_{*global*,1} ··· *H*_{*global,c*-1}], and FIG. 6 shows an example in which the first check matrix includes c first check submatrices) and at least one second check submatrix (*H_{local} =* [*H*_{*local*,0} *H*_{*local,*1} ··· *H*_{*local,c-*1}], and FIG. 6 shows an example in which the first check matrix includes c second check submatrices).

The at least one first check submatrix has r rows and ${A}_{lt}^{′}$ columns. The at least one first check submatrix is used to encode the adjusted first source bits. For example, linear block code encoding is performed on the adjusted first source bits based on the at least one first check submatrix to obtain first encoded bits *u*_{*g*0}, where a code length before the encoding (that is, the adjusted first source bits) is *A_{gt},* and a code length after the encoding (that is, the first encoded bits) is ${A}_{lt}^{′} = {A}_{gt} + r$*.*

S403: Adjust a length of the first encoded bits to obtain adjusted first encoded bits.

To make the lengths of the plurality of second encoded bits subsequently obtained during segmentation of the first encoded bits the same, before the first encoded bits are segmented, the length of the first encoded bits may be adjusted to obtain the adjusted first encoded bits.

Still referring to FIG. 5, the code length of the first encoded bits *u*_{*g*0} is ${A}_{lt}^{′}$*.* If ${A}_{lt}^{′}$ is indivisible by c, bits are padded (for example, *cₚ* 0s are added) at a head, a tail, and/or a middle position of *u*_{*g*0}, where ${c}_{p} = {A}_{lt}^{′} - \left⌊{A}_{lt}^{′}/c\right⌋ ⋅ c$*. If* ${A}_{lt}^{′}$ is divisible by *c*, no addition is performed. *cₚ* = 0. An adjusted sequence (that is, the adjusted first encoded bits) is denoted as *u_{g},* and a length is ${A}_{lt} = {A}_{lt}^{′} + {c}_{p}$ *.* $\left⌊{A}_{lt}^{′}/c\right⌋$ indicates rounding down of ${A}_{lt}^{′} / c$*.*

It may be understood that, both step S403 and step S401 are performed to enable subsequent even and uniform segmentation to be performed. Length adjustment may be performed before and/or after the first source bit is encoded, that is, only step S401, only step S403, or step S403 and step S401 may be performed. This is not limited in this application.

S404: Segment the adjusted first encoded bits based on the first check matrix to obtain at least one second encoded bit.

After adjusting the length of the first encoded bits, the encoding apparatus segments the adjusted first encoded bits *u_{g}* based on the first check matrix to obtain the at least one second encoded bit. The first encoded bits include information bits and first check bits that are obtained by encoding the adjusted first source bits.

There may be the following two manners for segmentation.

In a manner, *u_{g}* is equally divided into c segments, and each segment is denoted as *u_{l,i} (i* = 0,1, ··· , *c* - 1), with a length of *Aₗ = Aₗₜ*/*c.*

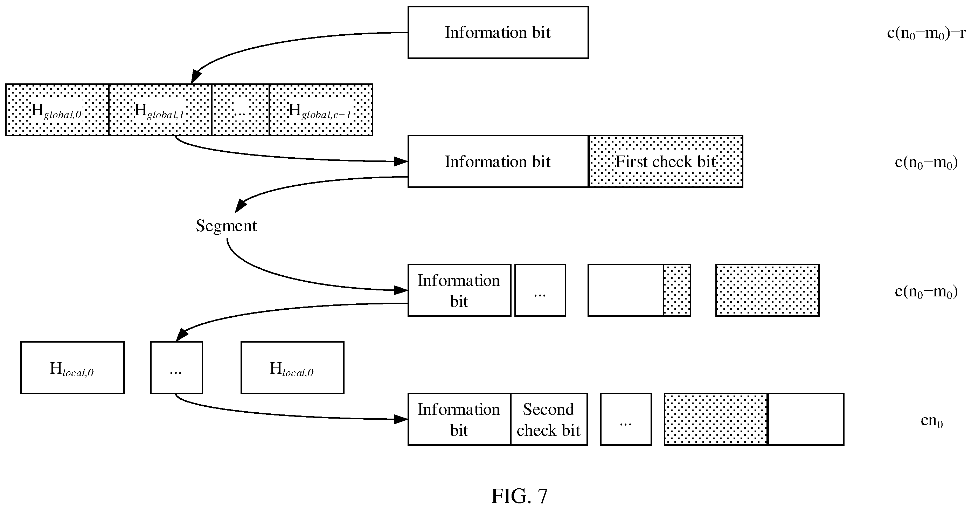

FIG. 7 is a diagram of an example of an equal division encoding scheme according to an embodiment of this application. A total length of the first source bit u is *A_{gt} = c*(*n*₀ - *m*ₒ) *- r.* The first source bits (or the first source bits after length adjustment is performed) are encoded by using the at least one first check submatrix (*H_{global}* = [*H*_{*global*,0} *H*_{*global*,1} ··· *H*_{*global,c-*1}]) to obtain the first encoded bits. A code length of the first encoded bits *u*_{*g*0} is ${A}_{lt}^{′} = c \left({n}_{0}-{m}_{0}\right)$. The first encoded bits (or the first encoded bits after length adjustment is performed) are segmented to obtain the at least one second encoded bit.

It can be learned from FIG. 7 that, all of the first check bits are appended to a tail of the information bits, and then are evenly segmented. In this way, all of the first check bits are located in later segments. A format of the obtained second encoded bit is as follows.

In an example, the second encoded bit includes a part of bits of the information bits.

In another example, the second encoded bit includes all bits of the information bits.

In still another example, the second encoded bit includes a part of bits of the first check bits.

In still another example, the second encoded bit includes all bits of the first check bits.

In still another example, the second encoded bit includes a part of bits of the information bits and a part of bits of the first check bits.

In still another example, the second encoded bit includes a part of bits of the information bits and all bits of the first check bits.

A code length of the at least one second encoded bit is *c*(*n*₀ - *m*₀).

In another manner, interleaving of *u_{g}* is p with a length of an interleaver of *Aₗₜ.* Then, an interleaved sequence is equally divided into *c* segments, and each segment is denoted as *u_{l,i} (i* = 0,1, ··· , *c* - 1), with a length of *Aₗ = Aₗₜ*/*c.*

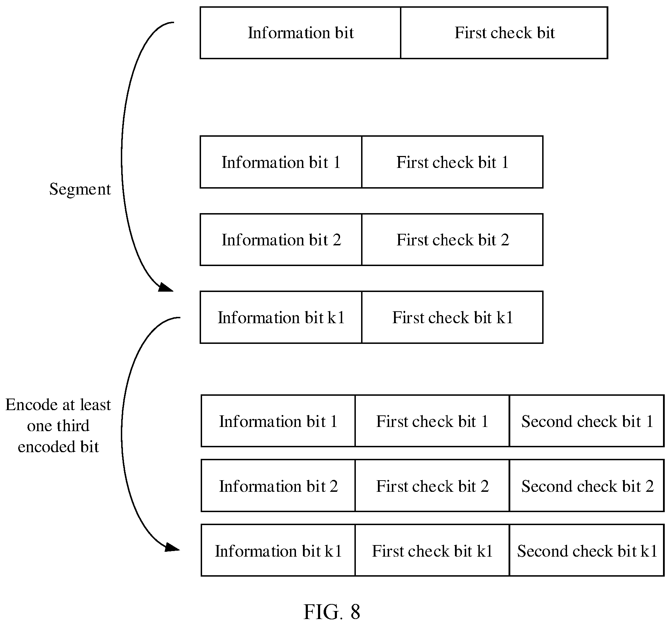

FIG. 8 is a diagram of an example of an interleaving encoding scheme according to an embodiment of this application. The first check bits are first evenly divided into *k*₁ segments, and the information bits are also evenly divided into *k*₁ segments, so that the first check bit is evenly placed at a tail of each information bit segment. A format of the obtained second encoded bit is as follows.

In an example, the second encoded bit includes all bits of the information bits and a part of bits of the first check bits.

In another example, the second encoded bit includes all bits of the information bits and all bits of the first check bits.

In still another example, the second encoded bit includes a part of bits of the information bits and a part of bits of the first check bits.

In still another example, the second encoded bit includes all bits of the information bits and a part of bits of the first check bits.

S405: Encode at least one third encoded bit based on the first check matrix to obtain at least one fourth encoded bit.

After the at least one second encoded bit is obtained by segmenting the adjusted first encoded bits, the at least one third encoded bit is encoded based on the first check matrix to obtain the at least one fourth encoded bit. The fourth encoded bit includes the information bit and a second check bit.

Specifically, the at least one third encoded bit may be encoded based on the at least one second check submatrix (*H_{local}* = [*H*_{*local*,0} *H*_{*local,*1} *··· H*_{*local,c*-1}]) to obtain the at least one fourth encoded bit. The at least one second encoded bit includes the at least one third encoded bit, that is, the at least one third encoded bit is a part or all of the at least one second encoded bit.

For example, linear block code encoding may be performed on *u_{l,i}* (*i* = 0,1, ··· , *c* - 1). Before the encoding, there are *Aₗ* bits, and a sequence (that is, the fourth encoded bit) after the encoding is denoted as *x_{l,i},* and a quantity of bits is *n*₀ *= Aₗ + m*₀*.*

For example, a code rate of the second check submatrix may be flexibly changed.

Still referring to FIG. 6, a total length of the adjusted first source bit u is ${A}_{gt} = \left({n}_{0}-{m}_{0}-\left⌈r/c\right⌉\right) ⋅ c$ . After the adjusted first source bits are encoded based on the first check matrix to obtain the first encoded bits, the length of the first encoded bits is adjusted, the adjusted first encoded bits are segmented to obtain the at least one second encoded bit, and the at least one third encoded bit is encoded based on the first check matrix. A length of each second encoded bit obtained through segmentation is *Aₗ = n*₀ - *m*₀, and the at least one fourth encoded bit is obtained by encoding the at least one third encoded bit, with a length of each fourth encoded bit of *n*₀.

It can be learned that in FIG. 6, in the at least one first check submatrix and the at least one second check submatrix, a value of at least one second element, corresponding to a position of at least one first element at a tail of the second check submatrix, at a tail of the first check submatrix is zero. When the at least one third encoded bit is encoded, a feature of the matrix enables flexible generation of redundant bits to be supported, so that the encoding may support flexible code rate adaption and incremental redundancy hybrid automatic repeat request (incremental redundancy hybrid automatic repeat request, IR-HARQ). The feature of the matrix structure is merely an example. This is not limited in this application.

S406: Determine at least one sixth encoded bit based on the at least one fourth encoded bit.

Still referring to FIG. 5, for example, *x_{l,i}* may be concatenated based on an order of *i* = 0,1, ··· *c* - 1 to obtain a sequence *xₗ,* with a length of *n*₀*c.*

According to the encoding method provided in this embodiment of this application, the first source bits are encoded to obtain the first encoded bits, the first encoded bits are segmented, and then the encoded bits obtained through segmentation are encoded. Both the information bits and the first check bits of the first encoded bits are used as information bits for re-encoding, thereby improving design flexibility of the first check matrix, improving encoding efficiency, and improving encoding performance. In addition, flexible code rate adaptation and IR-HARQ retransmission are supported when the encoded bit obtained through segmentation is encoded.

In the foregoing embodiments, an example in which a linear block code encoding manner may be used for encoding is used. The following embodiments describe that the first source bits (or the first source bits after length adjustment is performed) may be encoded by using the at least one first check submatrix in a sliding window structure, to further improve encoding performance.

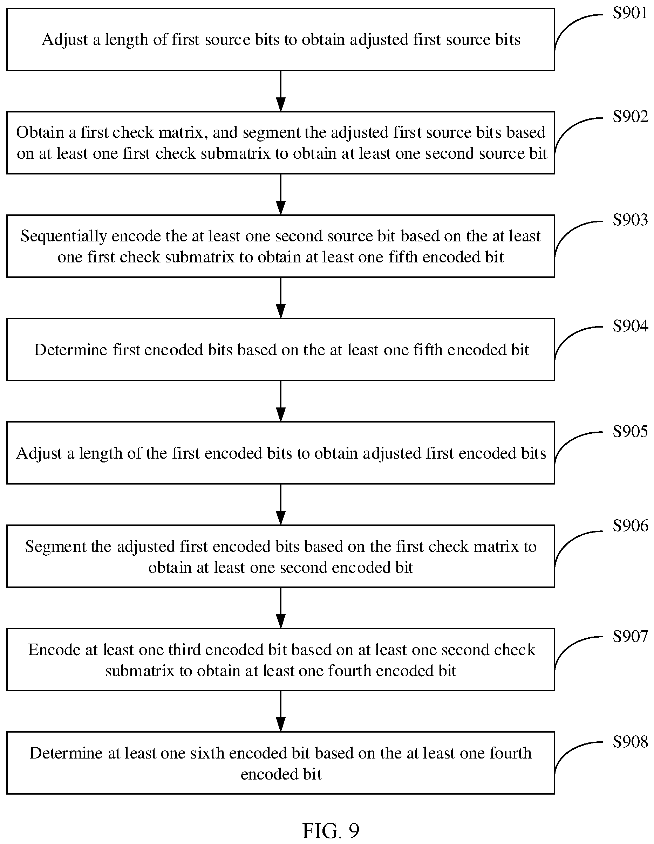

FIG. 9 is a schematic flowchart of still another encoding method according to an embodiment of this application. For example, the method may include the following steps.

S901: Adjust a length of first source bits to obtain adjusted first source bits.

To make a length of at least one second source bit subsequently obtained during segmentation of the adjusted first source bit the same, before the first source bits are segmented, the length of the first source bits may be adjusted to obtain the adjusted first source bits.

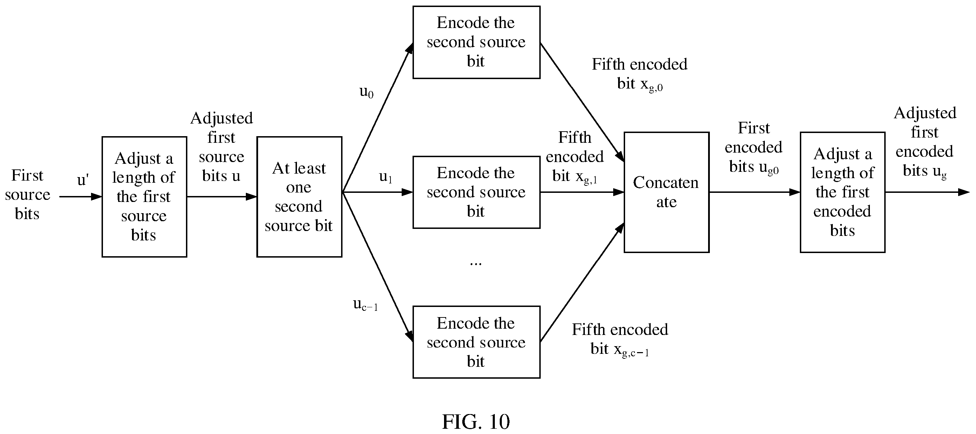

FIG. 10 is a diagram of an example of another encoding procedure according to an embodiment of this application. A length of first source bits u' is *A'* bits, and the first source bits are divided into c encoded bits for coupling. In this case, a total length of adjusted first source bits u is *A_{gt}* = *A'+Aₚ.*

For a specific implementation of adjusting the length of the first source bits, refer to step S401 in the embodiment shown in FIG. 4. Details are not described herein again.

S902: Obtain a first check matrix, and segment the adjusted first source bits based on at least one first check submatrix to obtain the at least one second source bit.

Before performing encoding, an encoding apparatus obtains the first check matrix. The encoding apparatus may obtain the first check matrix from a memory of the encoding apparatus, or obtain the first check matrix from another apparatus or device.

In this embodiment, the first check matrix includes the at least one first check submatrix and at least one second check submatrix. The encoding apparatus segments the adjusted first source bits based on the at least one first check submatrix to obtain the at least one second source bit.

Still referring to FIG. 10, a sequence (that is, the first source bits after length adjustment is performed) u with a length of *A_{gt}* is evenly divided into c segments, and each segment is denoted as *uᵢ (i* = 0,1, ... , *c* - 1), with a length of each segment of *n*₀ - *m*₀ -*r*.

S903: Sequentially encode the at least one second source bit based on the at least one first check submatrix to obtain at least one fifth encoded bit.

In this embodiment, one first check submatrix in the at least one first check submatrix is obtained by coupling all first check submatrices in a first sliding window length.

The at least one second source bit is encoded based on the at least one first check submatrix to obtain the at least one fifth encoded bit.

For example, the first sliding window length is denoted as *L.* In this case,
a second information bit *u*₀ is encoded based on a first check submatrix *H*_{*global,*0} to obtain *x*_{*g*,0};
a second information bit *u*₁ is encoded based on first check submatrices *H*_{*global,*0}*, H*_{*global*,1} to obtain *x*_{*g*,1}; ...
a second information bit *uⱼ* is encoded based on first check submatrices *H*_{*global,j-L+*1}*, H*_{*global,j-L+*2}*,* ... , *H_{global,j}* to obtain *x_{g,j}* (*j* ≥ *L*).

For each first check submatrix *H_{global,j},* the submatrix has *r'* rows and (*n*₀ *- m*₀) columns.

When r is divisible by *c*, a value of *r'* may be *r*/*c*, that is, each local encoding matrix obtains r/c check bits.

When r is indivisible by c, an allocation scheme of the value is: A value of *r'* for first c-1 blocks is $\left⌈r/c\right⌉$*.* $\left⌈⋅\right⌉$ indicates rounding up, and a value of *r'* for a last block is $r - \left⌈r/c\right⌉ ⋅ c$*.*

The following are two examples of the first check matrix.

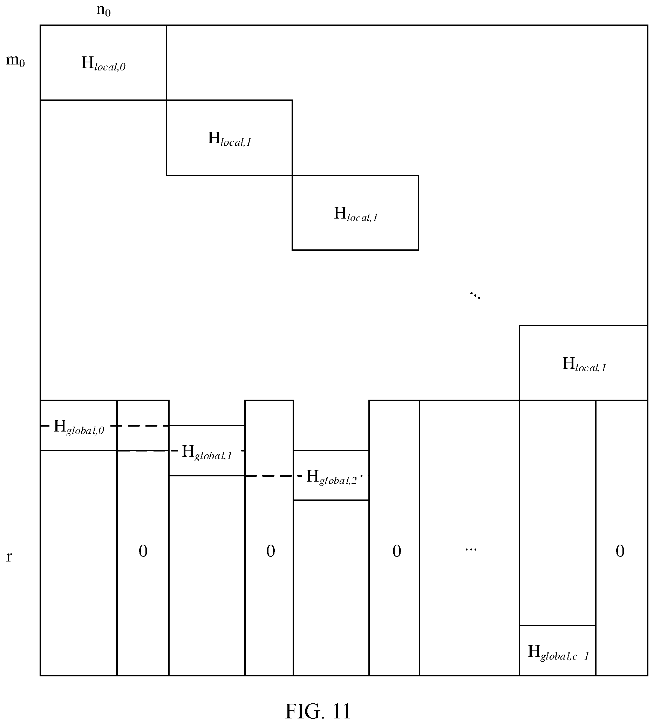

FIG. 11 is a diagram of an example of another first check matrix according to an embodiment of this application. The first check matrix includes at least one first check submatrix (*H_{global}* = [*H*_{*global*,0} *H*_{*global*,1} ··· *H*_{*global,c-*1}]) and at least one second check submatrix (*H_{local}* = [*H*_{*local*,0} *H*_{*local,*1} ··· *H*_{*local,c-*1}]*).* In this embodiment, for the second check submatrix, still refer to the foregoing descriptions. The first check submatrix is obtained by coupling at least one first check submatrix in a first sliding window length, with the first sliding window length of *L* = 2. In this case,
a second information bit *u*₀ is encoded based on the first check submatrix *H*_{*global,*0} to obtain *x*_{*g*,0}; and
a second information bit *uⱼ* is encoded based on first check submatrices *H*_{*global,j-*1}*, H_{global,j}* to obtain *x_{g,j}* (*1* ≤ *j* ≤ *c -* 1).

It may be understood that, in FIG. 11, both a block marked as 0 and a blank position that is not marked are 0s.

It can be learned that, starting from the first check submatrix *H*_{*global,*1}, a coupling relationship exists between two first check submatrices. This is reflected in that in the at least one first check submatrix, each matrix *H_{global,j}* is equally divided into three parts: an upper part and a lower part from top to bottom. The upper part is in a same row as a previous first check submatrix, and a left side of the lower part is all 0s. *H*_{*global*,1} is used as an example. A coupling relationship exists between two first check submatrices (*H*_{*global,*0} and *H*_{*olobal,*1}). This is reflected in that the matrix *H*_{*global*,1} is equally divided into three parts: an upper part and a lower part from top to bottom. The upper part is in a same row as a previous first check submatrix (*H*_{*global,*0} or *H*_{*global,*1}), and a left side of the lower part is all 0s.

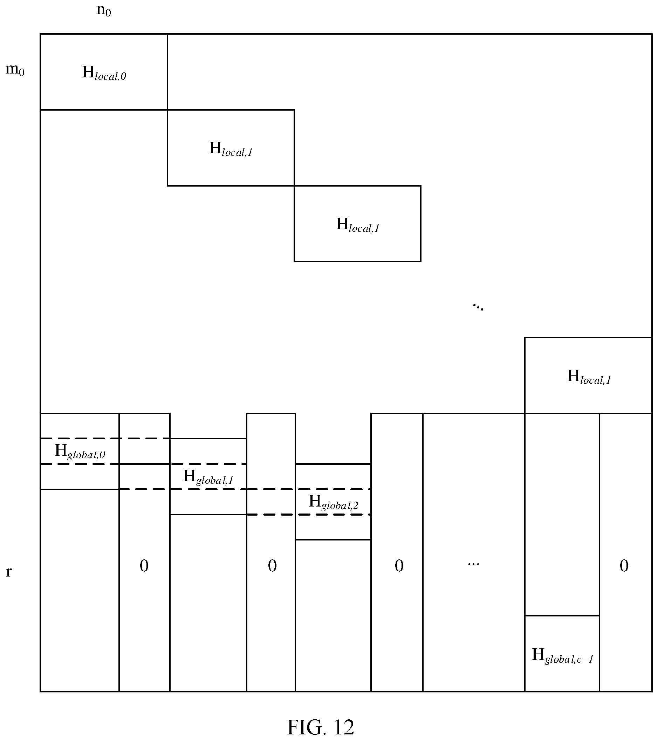

FIG. 12 is a diagram of an example of still another first check matrix according to an embodiment of this application. The first check matrix includes at least one first check submatrix (*H_{global}* = [*H*_{*global*,0} *H*_{*global*,1} ··· *H*_{*global,c-*1}]) and at least one second check submatrix (*H_{local}* = [*H*_{*local*,0} *H*_{*local,*1} ··· *H*_{*local,c-*1}]*).* In this embodiment, for the second check submatrix, still refer to the foregoing descriptions. The first check submatrix in the at least one first check submatrix is obtained by coupling all first check submatrices in a first sliding window length, with the first sliding window length of *L* = 3. In this case,
a second information bit *u*₀ is encoded based on the first check submatrix *H*_{*global,*0} to obtain *x*_{*g,*0};
a second information bit *u*₁ is encoded based on first check submatrices *H*_{*global,*0}*, H*_{*global*,1} to obtain *x*_{*g*,1}; and
a second information bit *uⱼ* is encoded based on first check submatrices *H*_{*global,j-*2}*, H*_{*global,j-*1}*, H_{global,j}* to obtain *x_{g,j} (2* ≤ *j ≤ c -* 1).

It can be learned that, starting from the first check submatrix *H*_{*global,*2}*,* a coupling relationship exists between three first check submatrices. This is reflected in that in the at least one first check submatrix, each matrix *H_{global,j}* is equally divided into three parts: an upper part, a middle part, and a lower part from top to bottom. The upper part is in a same row as first two first check submatrices, the middle part is in a same row as a previous check submatrix, and a left side of the lower part is all 0s. *H*_{*global,*2} is used as an example. A coupling relationship exists between three first check submatrices (*H*_{*global,*0}*, H*_{*global,*1}, and *H*_{*global,*2}). This is reflected in that the *H*_{*global,*2} is equally divided into three parts: an upper part, a middle part, and a lower part from top to bottom. The upper part is in a same row as first two first check submatrices (*H*_{*global,*0} and *H*_{*global,*1}), the middle part is in a same row as the previous check submatrix (*H*_{*global,*1}), and a left side of the lower part is all 0s.

S904: Determine the first encoded bits based on the at least one fifth encoded bit.

For example, after encoding the at least one second source bit to obtain the at least one fifth encoded bit, the encoding apparatus may concatenate the at least one fifth encoded bit to obtain the first encoded bits.

Still referring to FIG. 10, the encoding apparatus arranges *x_{g,j}* (*j* = 0,1, ..., *c* - 1) in a sequential order to obtain *u*_{*g*0}.

S905: Adjust a length of the first encoded bits to obtain adjusted first encoded bits.

S906: Segment the adjusted first encoded bits based on the first check matrix to obtain at least one second encoded bit.

S907: Encode at least one third encoded bit based on the at least one second check submatrix to obtain at least one fourth encoded bit.

S908: Determine at least one sixth encoded bit based on the at least one fourth encoded bit.

For specific implementations of step S905 to step S908, refer to step S403 to step S406 in the embodiment shown in FIG. 4. Details are not described herein again.

According to the encoding method provided in this embodiment of this application, the first source bits are encoded to obtain the first encoded bits, the first encoded bits are segmented, and then the encoded bits obtained through segmentation are encoded. The first check matrix used in the encoding method is flexibly designed, thereby improving encoding efficiency and improving encoding performance. In addition, in the first check matrix, the first check submatrix is obtained by coupling the at least one first check submatrix in the first sliding window length, so that the encoding is simpler, hardware complexity is low, decoding is more suitable for being performed in a serial manner, and it is easier for subsequent encoded bits to use decoding information of preceding encoded bits.

The foregoing embodiments describe that the first check matrix includes the at least one first check submatrix and the at least one second check submatrix. In a case, when the at least one first check submatrix and the at least one second check submatrix are used for encoding, linear block code encoding may be used for both the at least one first check submatrix and the at least one second check submatrix. In another case, when the at least one first check submatrix is used for encoding, the first check submatrix in the at least one first check submatrix is obtained by coupling all the first check submatrices in the first sliding window length, and when the at least one second check submatrix is used for encoding, linear block code encoding may be used for the at least one second check submatrix.

The following embodiments describe that when the at least one second check submatrix is used for encoding, one second check submatrix in the at least one second check submatrix may also be obtained by coupling all second check submatrices in a second sliding window length.

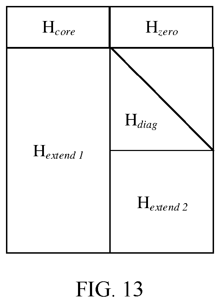

The second check submatrix is an QC-LDPC base matrix. FIG. 13 is a diagram of an example of the second check submatrix according to an embodiment of this application. The second check submatrix includes a core matrix *H_{core},* an all-zero matrix *H_{zero},* a first extended matrix *H*_{*extend* 1}, a diagonal matrix *H_{diag},* and a second extended matrix *H*_{*extend* 2}*.*

*H_{zero}* has a same quantity of rows as *H_{core},* and is located on the right of *H_{core}.*

*H*_{*extend* 1} has a small row weight (a quantity of 1s in each row), and has sparser elements than that of *H_{core}*.

*H_{diag}* has only '1' on diagonal elements. The matrix mainly supports flexible code rates of LDPC codes, and is cropped from an upper left corner to a lower right corner based on different code rate requirements.

*H*_{*extend* 2} includes two implementations. Manner 1 is a matrix with a small row weight, and a feature of the matrix is consistent with that of the first extended matrix. Manner 2 is an all-zero matrix.

In this embodiment, when the at least one third encoded bit is encoded based on the at least one second check submatrix to obtain the at least one fourth encoded bit, the second check submatrix uses a sliding window structure, that is, the second check submatrix in the at least one second check submatrix is obtained by coupling all the second check submatrices in the second sliding window length.

Different from the embodiment shown in FIG. 3 or FIG. 4, when linear block code encoding is performed on a source bit (or source bit after length adjustment is performed), LDPC encoding of each *u_{l,i} (i* = 0,1, ··· , *c* - 1) may be performed independently. Herein, LDPC encoding of each fourth encoded bit is related to a current third encoded bit and several previous third encoded bits.

The sliding window structure is used in an LDPC encoding process, and the second sliding window length is denoted as *L*. In this case,
LDPC code encoding is performed on *H*_{*local,*0} to obtain *u*_{*l,*0};
LDPC code encoding is performed on *H*_{*local,*1}, *H*_{*local,*0} to obtain *u*_{*l,*1}; ...
LDPC code encoding is performed on *H*_{*local,j-L+*1}*, H*_{*local,j-L+*2}*, H_{local,j}* to obtain *u_{l,j}.*

A quantity of check bits obtained by encoding each third encoded bit is *m*₀, and each encoding result is denoted as *u*_{*l,*0} (*i* = 0,1, ··· , *c* - 1).

The following are two examples of the first check matrix.

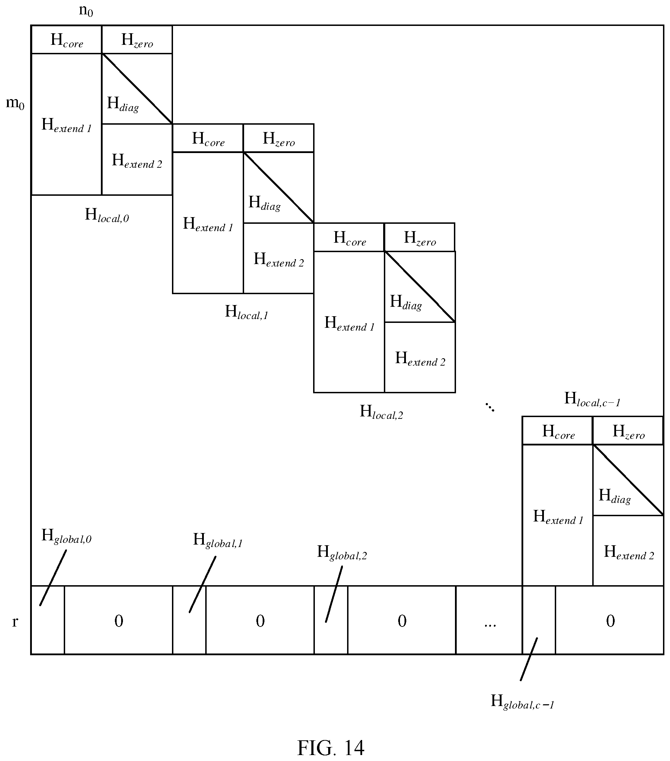

FIG. 14 is a diagram of an example of still another first check matrix according to an embodiment of this application. In the first check matrix, when the at least one first check submatrix is used to encode the first source bits (or the first source bits after length adjustment is performed, or the at least one second source bit), the matrix is still divided into *c* non-zero blocks, an information bit length of each block is *A_{gt}*/*c* (in an example, it is assumed that *A_{gt}* is divisible by c; or if *A_{gt}* is indivisible by c, c - 1 blocks of $\left⌈{A}_{gt}/c\right⌉$ and one block of ${A}_{gt} - \left⌈{A}_{gt}/c\right⌉ ⋅ c$ are obtained through division). A length of each non-zero block in the first check submatrix is *n*₀ - *m*₀, with a quantity of rows of r. The first check submatrix corresponds to a column in which an information bit of the second check submatrix is located, that is, a result obtained through encoding by using the first check submatrix is used as an information bit for next encoding.

When the at least one second check submatrix is used to encode the at least one third encoded bit, a coupling relationship of the encoding is that the core matrix of the second check submatrix is aligned with the top of a second extended matrix of a previous second check submatrix of the second check submatrix. This enables a feature of flexible code rate adjustment still to be implemented based on *H_{diag}* when sliding window encoding is performed by using different LDPC codes. In FIG. 14, the second sliding window length is L=2, that is, a current encoding result is related only to an information bit of the current third encoded bit, an information bit of a previous encoding result, and a check bit of the previous encoding result (optionally, an exclusion is made if *H*_{*extend* 2} is an all-zero matrix).

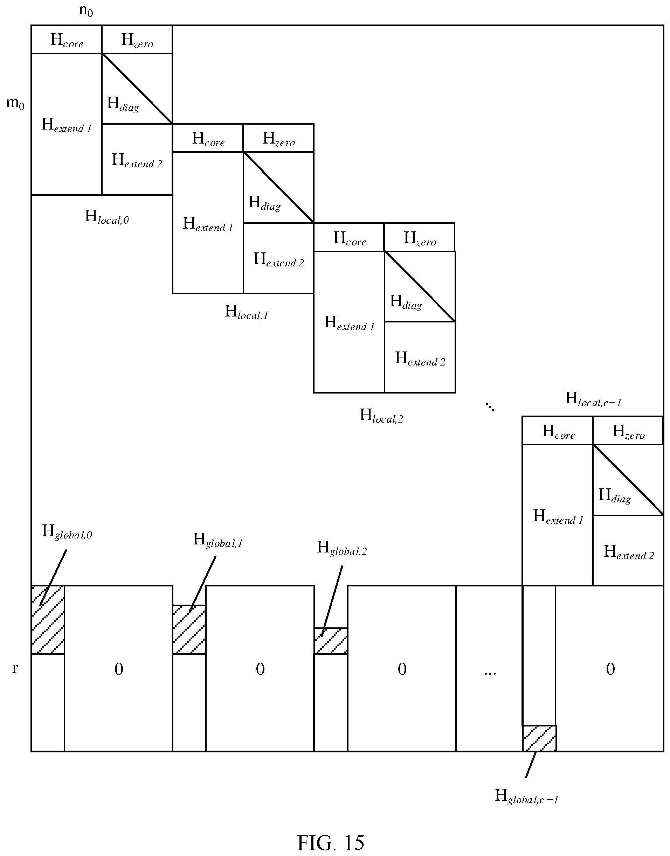

FIG. 15 is a diagram of an example of still another first check matrix according to an embodiment of this application. In the first check matrix, when the at least one first check submatrix and the at least one second check submatrix are used for encoding, an LDPC code in a sliding window structure is used for both the at least one first check submatrix and the at least one second check submatrix. When the at least one first check submatrix in the sliding window structure and the at least one second check submatrix in the sliding window structure are used for encoding, reference may be made to the foregoing descriptions.

According to the solution in this embodiment, the second extended matrix may be flexibly cropped (for example, flexible rates mainly require that a quantity of rows of the matrix be different, and the second extended matrix supports cropping from top to bottom to obtain required sizes based on different requirements, but does not affect encoding output results). Therefore, the flexible cropping is a conventional technology of 5G, and in this implementation, the technology is used for coupling of a plurality of encoded bits, so that encoding results can also support a flexible rate change.

The foregoing mainly describes, from a perspective of a transmitter device, the solutions provided in embodiments of this application. Correspondingly, embodiments of this application further provide an encoding apparatus. The encoding apparatus is configured to implement the foregoing various methods. The encoding apparatus may be the transmitter device in the foregoing method embodiments, or may be a component that can be used in the transmitter device. It may be understood that, to implement the foregoing functions, the encoding apparatus includes a corresponding hardware structure and/or a software module for performing each function. A person skilled in the art should be easily aware that, in combination with units and algorithm steps of the examples described in embodiments disclosed in this specification, this application can be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, the encoding apparatus may be divided into functional modules based on the foregoing method embodiments. For example, each functional module may be obtained through division based on each corresponding function, or two or more functions may be integrated into one processing unit. The integrated module may be implemented in a form of hardware, or may be implemented in a form of a software functional module. It should be noted that, in embodiments of this application, division into modules is an example, and is merely logical function division. During an actual implementation, another division manner may be used.

Based on a same concept of the foregoing encoding method, this application further provides the following encoding apparatus.

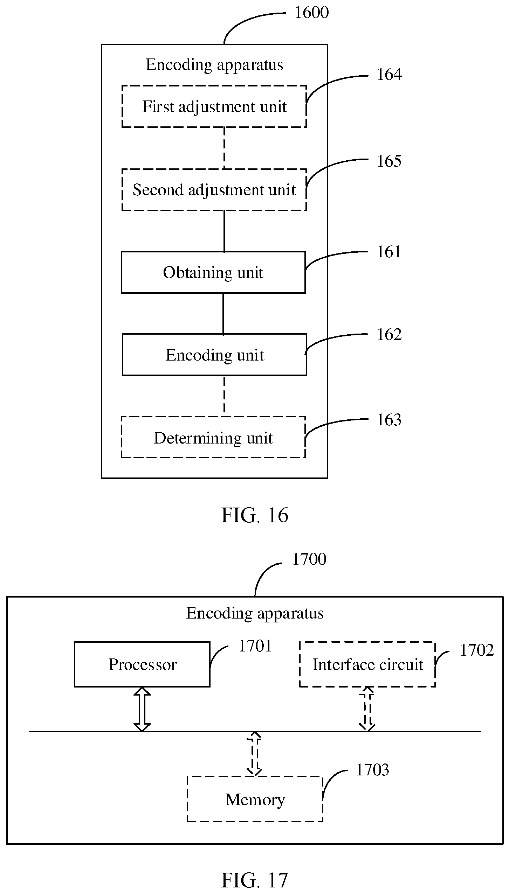

FIG. 16 is a diagram of a structure of an encoding apparatus according to an embodiment of this application. The encoding apparatus 1600 includes:
an obtaining unit 161, configured to obtain a first check matrix; and an encoding unit 162, configured to encode first source bits based on the first check matrix to obtain first encoded bits. The encoding unit 162 is further configured to segment the first encoded bits based on the first check matrix to obtain at least one second encoded bit; and the encoding unit 162 is further configured to encode at least one third encoded bit based on the first check matrix to obtain at least one fourth encoded bit, where the at least one second encoded bit includes the at least one third encoded bit.

Optionally, the apparatus further includes a first adjustment unit 164 (represented by dashed lines in FIG. 16), configured to: before the encoding unit segments the first encoded bits based on the first check matrix, adjust a length of the first encoded bits to obtain adjusted first encoded bits. In addition, the encoding unit 162 is further configured to segment the adjusted first encoded bits based on the first check matrix.

Optionally, the first adjustment unit 164 is configured to pad bits at a head, a tail, and/or a middle position of the first encoded bits.

Optionally, the apparatus further includes a second adjustment unit 165 (represented by dashed lines in FIG. 16), configured to: before the encoding unit encodes the first source bits based on the first check matrix, adjust a length of the first source bits to obtain adjusted first source bits. In addition, the encoding unit 162 is further configured to encode the adjusted first source bits based on the first check matrix.

Optionally, the second adjustment unit 165 is configured to pad bits at a head, a tail, and/or a middle position of the first source bits.

Optionally, the first encoded bits include information bits and first check bits that are obtained by encoding the source bits; and the second encoded bit includes a part/all of bits of the information bits and/or a part/all of bits of the first check bits.

Optionally, the first check matrix includes at least one first check submatrix and at least one second check submatrix, the at least one first check submatrix is used to encode the first source bits, and the at least one second check submatrix is used to encode the at least one third encoded bit.

Optionally, a value of at least one second element at a tail of one first check submatrix in the at least one first check submatrix is 0, and a position of the at least one second element corresponds to at least one first element at a tail of one second check submatrix in the at least one second check submatrix.

Optionally, one first check submatrix in the at least one first check submatrix is obtained by coupling all first check submatrices in a first sliding window length.

Optionally, the encoding unit 162 is further configured to segment the first source bits based on the at least one first check submatrix to obtain at least one second source bit; the encoding unit 162 is further configured to encode the at least one second source bit based on the at least one first check submatrix to obtain at least one fifth encoded bit; and the encoding unit 162 is further configured to determine the first encoded bits based on the at least one fifth encoded bit.

Optionally, one second check submatrix in the at least one second check submatrix is obtained by coupling all second check submatrices in a second sliding window length.

Optionally, the second check submatrix in the at least one second check submatrix includes a core matrix, an all-zero matrix, a first extended matrix, a diagonal matrix, and a second extended matrix, and the core matrix of the second check submatrix is aligned with the top of a second extended matrix of a previous second check submatrix of the second check submatrix.

Optionally, the apparatus further includes a determining unit 163 (represented by dashed lines in FIG. 16), configured to determine at least one sixth encoded bit based on the at least one fourth encoded bit.

In this application, division into modules is an example, and is merely logical function division. During an actual implementation, another division manner may be used. In addition, functional modules in the examples of this application may be integrated into one processor, each of the modules may exist alone physically, or two or more modules may be integrated into one module. The integrated module may be implemented in a form of hardware, or may be implemented in a form of a software functional module.

For specific implementation of the foregoing units, refer to related descriptions in the embodiments shown in FIG. 3, FIG. 4, and FIG. 9.

FIG. 17 is a diagram of a structure of another encoding apparatus according to an embodiment of this application. The encoding apparatus 1700 includes a processor 1701. Optionally, the encoding apparatus 1700 may further include an interface circuit 1702 (represented by dashed lines in FIG. 17). The processor 1701 and the interface circuit 1702 are coupled to each other. It may be understood that, the interface circuit 1702 may be a transceiver or an input/output interface. Optionally, the encoding apparatus 1700 may further include a memory 1703 (represented by dashed lines in FIG. 17). The memory 1703 is configured to store instructions executed by the processor 1701, store input data required by the processor 1701 to run the instructions, or store data generated after the processor 1701 runs the instructions.

The processor 1701 is configured to perform the following operations: obtaining a first check matrix, and encoding first source bits based on the first check matrix to obtain first encoded bits; segmenting the first encoded bits based on the first check matrix to obtain at least one second encoded bit; and encoding at least one third encoded bit based on the first check matrix to obtain at least one fourth encoded bit, where the at least one second encoded bit includes the at least one third encoded bit.

Optionally, the processor 1701 is further configured to perform the following operations: before segmenting the first encoded bits based on the first check matrix, adjusting a length of the first encoded bits to obtain adjusted first encoded bits; and segmenting the adjusted first encoded bits based on the first check matrix.

Optionally, that the processor 1701 performs the operation of adjusting the length of the first encoded bits to obtain the adjusted first encoded bits includes padding bits at a head, a tail, and/or a middle position of the first encoded bits.

Optionally, the processor 1701 is further configured to perform the following operations: before encoding the first source bits based on the first check matrix, adjusting a length of the first source bits to obtain adjusted first source bits; and encoding the adjusted first source bits based on the first check matrix.

Optionally, that the processor 1701 performs the operation of adjusting the length of the first source bits to obtain the adjusted first source bits includes padding bits at a head, a tail, and/or a middle position of the first source bits.

Optionally, the first encoded bits include information bits and first check bits that are obtained by encoding the source bits; and the second encoded bit includes a part/all of bits of the information bits and/or a part/all of bits of the first check bits.

Optionally, the first check matrix includes at least one first check submatrix and at least one second check submatrix, the at least one first check submatrix is used to encode the first source bits, and the at least one second check submatrix is used to encode the at least one third encoded bit.

Optionally, a value of at least one second element at a tail of one first check submatrix in the at least one first check submatrix is 0, and a position of the at least one second element corresponds to at least one first element at a tail of one second check submatrix in the at least one second check submatrix.

Optionally, one first check submatrix in the at least one first check submatrix is obtained by coupling all first check submatrices in a first sliding window length.

Optionally, the processor 1701 is further configured to perform the following operations: segmenting the first source bits based on the at least one first check submatrix to obtain at least one second source bit; encoding the at least one second source bit based on the at least one first check submatrix to obtain at least one fifth encoded bit; and determining the first encoded bits based on the at least one fifth encoded bit.

Optionally, one second check submatrix in the at least one second check submatrix is obtained by coupling all second check submatrices in a second sliding window length.

Optionally, the second check submatrix in the at least one second check submatrix includes a core matrix, an all-zero matrix, a first extended matrix, a diagonal matrix, and a second extended matrix, and the core matrix of the second check submatrix is aligned with the top of a second extended matrix of a previous second check submatrix of the second check submatrix.

Optionally, the processor 1701 is further configured to perform the following operation: determining at least one sixth encoded bit based on the at least one fourth encoded bit.

It may be understood that, the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor or any conventional processor.

An embodiment of this application further provides a computer-readable storage medium. The computer-readable storage medium stores a computer program or instructions. When the computer program or the instructions are executed, the method in the foregoing embodiments is implemented.

An embodiment of this application further provides a computer program product including instructions. When the instructions are run on a computer, the computer is caused to perform the method in the foregoing embodiments.

An embodiment of this application further provides a circuit. The circuit is coupled to a memory, and the circuit is configured to perform the method shown in the foregoing embodiments. The circuit may include a chip circuit.

An embodiment of this application further provides a chip apparatus, including a processor configured to invoke a computer degree or computer instructions stored in a memory, to enable the processor to perform the method provided in any one of the embodiments shown in FIG. 3, FIG. 4, and FIG. 9.

In a possible implementation, an input of the chip apparatus corresponds to a receiving operation in any one of the embodiments shown in FIG. 3, FIG. 4, and FIG. 9, and an output of the chip apparatus corresponds to a sending operation in any one of the embodiments shown in FIG. 3, FIG. 4, and FIG. 9.

Optionally, the processor is coupled to a memory through an interface.

Optionally, the chip apparatus further includes the memory, and the memory stores the computer degree or the computer instructions.

It should be noted that, one or more of the foregoing units or units may be implemented by software, hardware, or a combination of software and hardware. When any one of the foregoing units or units is implemented by software, the software exists in a form of computer program instructions, and is stored in a memory. A processor may be configured to execute the program instructions and implement the foregoing method procedures.

In this application, the processor may be a general-purpose processor, a digital signal processor, an application-specific integrated circuit, a field programmable gate array or another programmable logic device, a discrete gate or a transistor logic device, or a discrete hardware component, and may implement or perform the methods, steps, and logical block diagrams disclosed in this application. The general-purpose processor may be a microprocessor, any conventional processor, or the like. The steps of the methods disclosed with reference to this application may be directly performed and completed by a hardware processor, or may be performed and completed by a combination of hardware and a software module in the processor.

When the foregoing units or units are implemented by hardware, the hardware may be any one or any combination of a CPU, a microprocessor, a digital signal processing (digital signal processing, DSP) chip, a microcontroller unit (microcontroller unit, MCU), an artificial intelligence processor, an ASIC, a SoC, an FPGA, a PLD, a dedicated digital circuit, a hardware accelerator, or a non-integrated discrete device. The hardware may run necessary software or does not depend on software to perform the foregoing method procedures.

Optionally, an embodiment of this application further provides a chip system, including at least one processor and an interface. The at least one processor is coupled to a memory through the interface. When the at least one processor runs a computer program or instructions in the memory, the chip system is enabled to perform the method in any one of the foregoing method embodiments. Optionally, the chip system may include a chip, or may include the chip and another discrete device. This is not specifically limited in this embodiment of this application.

Alternatively, the memory in this application may be a circuit or any other apparatus that can implement a storage function, and is configured to store program instructions and/or data. The memory is any other medium that can be configured to carry or store expected program code in a form of an instruction or a data structure and that can be accessed by a computer, but is not limited thereto. For example, the memory may be a non-volatile memory, for example, a digital versatile disc (digital versatile disc, DVD), a hard disk drive (hard disk drive, HDD), or a solid-state drive (solid-state drive, SSD), or may be a volatile memory (volatile memory), for example, a random access memory (random access memory, RAM).

It may be understood that, in this application, an "indication" may include a direct indication, an indirect indication, an explicit indication, and an implicit indication. When a piece of indication information is described as indicating A, it may be understood that the indication information carries A, directly indicates A, or indirectly indicates A. In this application, information indicated by the indication information is referred to as to-be-indicated information. In a specific implementation process, there are many manners of indicating the to-be-indicated information. For example, the manners include but are not limited to a manner in which the to-be-indicated information, for example, the to-be-indicated information itself or an index of the to-be-indicated information, may be directly indicated, or a manner in which the to-be-indicated information may be indirectly indicated by indicating other information. There is an association relationship between the other information and the to-be-indicated information. Alternatively, only a part of the to-be-indicated information may be indicated, and the other part of the to-be-indicated information is known or pre-agreed on. For example, specific information may alternatively be indicated by using an arrangement order of a plurality of pieces of information that is pre-agreed on (for example, stipulated in a protocol), to reduce indication overheads to some extent. The to-be-indicated information may be sent as a whole, or may be divided into a plurality of pieces of sub-information for separate sending. In addition, sending periodicities and/or sending occasions of these pieces of sub-information may be the same or different. A specific sending method is not limited in this application. The sending periodicities and/or the sending occasions of these pieces of sub-information may be predefined, for example, predefined according to a protocol, or may be configured by a transmitter device by sending configuration information to a receiver device.

At least one piece (item) in this application indicates one piece (item) or a plurality of pieces (items). The plurality of pieces (items) mean two or more pieces (items). "And/or" describes an association relationship between associated objects and indicates that three relationships may exist. For example, A and/or B may indicate the following three cases: Only A exists, both A and B exist, and only B exists. The character "/" generally indicates an "or" relationship between the associated objects. In addition, it should be understood that, although terms such as first and second may be used in this application to describe objects, the objects are not limited to the terms. The terms are merely used to distinguish between the objects.

The terms "include", "have", and any variations thereof mentioned above are intended to cover a non-exclusive inclusion. For example, a process, a method, a system, a product, or a device that includes a series of steps or units is not limited to listed steps or units, but optionally further includes another unlisted step or unit, or optionally further includes another inherent step or unit of the process, the method, the product, or the device. It should be noted that, in this application, words such as "example" or "for example" indicate giving an example, an illustration, or a description. Any method or design scheme described as an "example" or "for example" in this application should not be construed as being more preferred or having more advantages than another method or design scheme. To be precise, use of the words such as "example" or "for example" is intended to present a related concept in a specific manner.

A network element in a communication system may send a signal to another network element or receive a signal from another network element. The signal may include information, signaling, data, or the like. The network element may alternatively be replaced with an entity, a network entity, a device, a terminal device, a communication module, a node, a communication node, or the like. In this application, the network element is used as an example for description. For example, the communication system may include at least one terminal device and at least one network device. The network device may send a downlink signal to the terminal device, and/or the terminal device may send an uplink signal to the network device. In addition, it may be understood that, if the communication system includes a plurality of terminal devices, the plurality of terminal devices may also send signals to each other. In other words, both a signal sending network element and a signal receiving network element may be terminal devices.

All or a part of the foregoing embodiments may be implemented by software, hardware, firmware, or any combination thereof. When a software program is used to implement the embodiments, all or a part of the embodiments may be implemented in a form of a computer program product. The computer program product includes one or more computer instructions. When the computer program instructions are loaded and executed on a computer, all or a part of procedures or functions according to embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, a computer, a server, or a data center to another website, computer, server, or data center in a wired (for example, a coaxial cable, an optical fiber, or a digital subscriber line (digital subscriber line, DSL)) or wireless (for example, infrared, radio, or microwave) manner.

Although this application is described with reference to the embodiments, in a process of implementing this application that claims protection, a person skilled in the art may understand and implement another variation of the disclosed embodiments by viewing the accompanying drawings, the disclosed content, and the appended claims. In the claims, the word "comprising" (comprising) does not exclude another component or another step, and "a" or "one" does not exclude a case of plurality. A single processor or another unit may implement several functions enumerated in the claims. Some measures are recorded in dependent claims that are different from each other, but this does not mean that these measures cannot be combined to produce better effects.

It may be understood that, various numbers in embodiments of this application are merely used for differentiation for ease of description, and are not used to limit the scope of embodiments of this application. Sequence numbers of the foregoing processes do not mean an execution order, and the execution order of the processes should be determined based on functions and internal logic of the processes.

In the foregoing embodiments, descriptions of the embodiments have respective focuses. For a part that is not described in detail in an embodiment, refer to related descriptions in other embodiments.

Components in the apparatus in embodiments of this application may be combined, divided, and deleted based on an actual requirement. A person skilled in the art may integrate or combine different embodiments or features of different embodiments described in this specification.

In this application, without a logical contradiction, examples can be referenced from each other. For example, methods and/or terms in the method embodiments can be referenced from each other, functions and/or terms in the apparatus embodiments can be referenced from each other, and functions and/or terms in the apparatus examples and the method examples can be referenced from each other.

## Claims

1. An encoding method, wherein the method comprises:
obtaining a first check matrix, and encoding first source bits based on the first check matrix to obtain first encoded bits;
segmenting the first encoded bits based on the first check matrix to obtain at least one second encoded bit; and
encoding at least one third encoded bit based on the first check matrix to obtain at least one fourth encoded bit, wherein the at least one second encoded bit comprises the at least one third encoded bit.

2. The method according to claim 1, wherein before segmenting the first encoded bits based on the first check matrix, the method further comprises:
adjusting a length of the first encoded bits to obtain adjusted first encoded bits; and
segmenting the first encoded bits based on the first check matrix comprises:
segmenting the adjusted first encoded bits based on the first check matrix.

3. The method according to claim 2, wherein adjusting the length of the first encoded bits comprises:
padding bits at a head, a tail, and/or a middle position of the first encoded bits.

4. The method according to any one of claims 1 to 3, wherein before encoding the first source bits based on the first check matrix, the method further comprises:
adjusting a length of the first source bits to obtain adjusted first source bits; and
encoding the first source bits based on the first check matrix comprises:
encoding the adjusted first source bits based on the first check matrix.

5. The method according to claim 4, wherein adjusting the length of the first source bits comprises:
padding bits at a head, a tail, and/or a middle position of the first source bits.

6. The method according to any one of claims 1 to 5, wherein the first encoded bits comprise information bits and first check bits that are obtained by encoding the first source bits; and
the second encoded bit comprises a part/all of bits of the information bits and/or a part/all of bits of the first check bits.

7. The method according to any one of claims 1 to 6, wherein the first check matrix comprises at least one first check submatrix and at least one second check submatrix, the at least one first check submatrix is used to encode the first source bits, and the at least one second check submatrix is used to encode the at least one third encoded bit.

8. The method according to claim 7, wherein a value of at least one second element at a tail of one first check submatrix in the at least one first check submatrix is 0, and a position of the at least one second element corresponds to at least one first element at a tail of one second check submatrix in the at least one second check submatrix.

9. The method according to claim 7, wherein one first check submatrix in the at least one first check submatrix is obtained by coupling all first check submatrices in a first sliding window length.

10. The method according to claim 9, wherein encoding the first source bits based on the first check matrix to obtain the first encoded bits comprises:
segmenting the first source bits based on the at least one first check submatrix to obtain at least one second source bit;
encoding the at least one second source bit based on the at least one first check submatrix to obtain at least one fifth encoded bit; and
determining the first encoded bits based on the at least one fifth encoded bit.

11. The method according to claim 7, wherein one second check submatrix in the at least one second check submatrix is obtained by coupling all second check submatrices in a second sliding window length.

12. The method according to claim 11, wherein the second check submatrix in the at least one second check submatrix comprises a core matrix, an all-zero matrix, a first extended matrix, a diagonal matrix, and a second extended matrix, and the core matrix of the second check submatrix is aligned with the top of a second extended matrix of a previous second check submatrix of the second check submatrix.

13. The method according to any one of claims 1 to 12, wherein the method further comprises:
determining at least one sixth encoded bit based on the at least one fourth encoded bit.

14. An encoding apparatus, wherein the apparatus comprises:
an obtaining unit, configured to obtain a first check matrix; and
an encoding unit, configured to encode first source bits based on the first check matrix to obtain first encoded bits, wherein
the encoding unit is further configured to segment the first encoded bits based on the first check matrix to obtain at least one second encoded bit; and
the encoding unit is further configured to encode at least one third encoded bit based on the first check matrix to obtain at least one fourth encoded bit, wherein the at least one second encoded bit comprises the at least one third encoded bit.

15. The apparatus according to claim 14, wherein the apparatus further comprises:
a first adjustment unit, configured to: before the encoding unit segments the first encoded bits based on the first check matrix, adjust a length of the first encoded bits to obtain adjusted first encoded bits, wherein
the encoding unit is further configured to segment the adjusted first encoded bits based on the first check matrix.

16. The apparatus according to claim 15, wherein the first adjustment unit is configured to pad bits at a head, a tail, and/or a middle position of the first encoded bits.

17. The apparatus according to any one of claims 14 to 16, wherein the apparatus further comprises:
a second adjustment unit, configured to: before the encoding unit encodes the first source bits based on the first check matrix, adjust a length of the first source bits to obtain adjusted first source bits, wherein
the encoding unit is further configured to encode the adjusted first source bits based on the first check matrix.

18. The apparatus according to claim 17, wherein the second adjustment unit is configured to pad bits at a head, a tail, and/or a middle position of the first source bits.

19. The apparatus according to any one of claims 14 to 18, wherein the first encoded bits comprise information bits and first check bits that are obtained by encoding the first source bits; and
the second encoded bit comprises a part/all of bits of the information bits and/or a part/all of bits of the first check bits.

20. The apparatus according to any one of claims 14 to 19, wherein the first check matrix comprises at least one first check submatrix and at least one second check submatrix, the at least one first check submatrix is used to encode the first source bits, and the at least one second check submatrix is used to encode the at least one third encoded bit.

21. The apparatus according to claim 20, wherein a value of at least one second element at a tail of one first check submatrix in the at least one first check submatrix is 0, and a position of the at least one second element corresponds to at least one first element at a tail of one second check submatrix in the at least one second check submatrix.

22. The apparatus according to claim 20, wherein one first check submatrix in the at least one first check submatrix is obtained by coupling all first check submatrices in a first sliding window length.

23. The apparatus according to claim 22, wherein
the encoding unit is further configured to segment the first source bits based on the at least one first check submatrix to obtain at least one second source bit;
the encoding unit is further configured to encode the at least one second source bit based on the at least one first check submatrix to obtain at least one fifth encoded bit; and
the encoding unit is configured to determine the first encoded bits based on the at least one fifth encoded bit.

24. The apparatus according to claim 20, wherein one second check submatrix in the at least one second check submatrix is obtained by coupling all second check submatrices in a second sliding window length.

25. The apparatus according to claim 24, wherein the second check submatrix in the at least one second check submatrix comprises a core matrix, an all-zero matrix, a first extended matrix, a diagonal matrix, and a second extended matrix, and the core matrix of the second check submatrix is aligned with the top of a second extended matrix of a previous second check submatrix of the second check submatrix.

26. The apparatus according to any one of claims 14 to 25, wherein the apparatus further comprises:
a determining unit, configured to determine at least one sixth encoded bit based on the at least one fourth encoded bit.

27. An encoding apparatus, comprising a memory, a processor, and a computer program that is stored in the memory and that can run on the processor, wherein the processor, when executing the computer program, implements the method according to any one of claims 1 to 13.

28. A chip, wherein the chip is configured to perform the method according to any one of claims 1 to 13.

29. A computer-readable storage medium, wherein the storage medium stores a computer program or instructions; and when the computer program or the instructions are executed by an encoding apparatus, the method according to any one of claims 1 to 13 is implemented.

30. A computer program product comprising instructions, wherein when the instructions are run on an encoding apparatus, the encoding apparatus is enabled to perform the method according to any one of claims 1 to 13.
